# EUROPÄISCHE PATENTANMELDUNG

(11) **EP 3 309 964 A1**
(43) Veröffentlichungstag der Anmeldung: **18.04.2018**
(21) Anmeldenummer: 16193902.0
(22) Anmeldetag: 14.10.2016
(51) Int. Cl.: H03K 17/18, H03K 17/16, H03K 17/0812, H02M 1/38

(54) **ANORDNUNG ZUR SCHALTZUSTANDSERKENNUNG EINES SPANNUNGSGESTEUERTEN HALBLEITERSCHALTELEMENTS**

(71) Anmelder: Siemens Aktiengesellschaft, 80333 München (DE)
(72) Erfinder: Neumeister, Matthias, 90469 Nürnberg (DE)

(57) **Zusammenfassung**

Die Erfindung betrifft eine Anordnung (10) zur Schaltzustandserkennung eines spannungsgesteuerten Halbleiterschaltelements (100, 200), insbesondere eines Leistungs-Halbleiterschaltelements, das einen Steueranschluss (101, 201) und einen Lastanschluss (102, 202) umfasst. Mittels einer zwischen dem Steueranschluss (101, 201) und dem Lastanschluss (102, 202) anfallenden Spannung (U_{GS}) wird das Halbleiterschaltelement (100, 200) leitend oder sperrend geschaltet. Die Anordnung umfasst ein Zustandserkennungsmittel (110, 210), das in Abhängigkeit der an dem Steueranschluss (101, 201) anliegenden Spannung ein Schaltzustandssignal (s100, s200) ausgibt, das anzeigt, ob das Halbleiterschaltelement leitet oder sperrt.

## Beschreibung

Die Erfindung betrifft eine Schaltzustandserkennung eines spannungsgesteuerten Halbleiterschaltelements, insbesondere eines Leistungs-Halbleiterschaltelements, das einen Steueranschluss und einen Lastanschluss umfasst, wobei mittels einer zwischen dem Steueranschluss und dem Lastanschluss anfallenden Spannung das Halbleiterschaltelement leitend oder sperrend geschaltet wird.

Spannungsgesteuerte Halbleiterschaltelemente kommen beispielsweise in Umrichtern zum Einsatz. Für die Stromkommutierung wird pro Phase beispielsweise eine Halbbrücke eingesetzt, welche zwei, mit ihrer Laststrecke seriell miteinander verschaltete, spannungsgesteuerte Halbleiterschaltelemente umfasst. In der Regel werden hierzu Leistungs-Metalloxidhalbleiter-Feldeffekttransistoren (MOSFET) verwendet. MOSFETs besitzen eine sog. Bodydiode, über die im sperrend geschalteten Zustand aufgrund einer am Ausgang der Halbbrücke angeschlossenen Induktivität ein Rückwärtsstrom fließen kann. Die Bodydiode ergibt sich aus der Struktur der MOSFETs, wodurch auf eine separate Freilaufdiode verzichtet werden kann.

In Umrichtern kommen in jüngerer Zeit Silicium-Carbid-Halbleiterschaltelemente (SiC-MOSFETs) zum Einsatz, welche durch ihren Aufbau ebenfalls eine Bodydiode aufweisen. Im Gegensatz zu Halbleiterschaltelementen aus Silicium (Si) ist bei SiC-MOSFETs die Schleusenspannung, d.h. die Spannung, die bei einem Stromfluss über die Bodydiode anfällt, deutlich größer. Daher entstehen in der Diodenleitphase sehr hohe Leitverluste. Um diese Verluste zu vermeiden, erfolgt eine Ansteuerung der SiC-MOSFETs derart, dass deren Laststrecke auch während der Diodenleitphase eingeschaltet wird. Das Sperrendschalten des SiC-MOSFET erfolgt dann, wenn der durch die Induktivität am Ausgang verursachte Strom durch die Bodydiode abgeklungen ist. Dieses Vorgehen erfordert jedoch eine genaue Kenntnis des jeweiligen Schaltzustands der MOSFETs einer Phase (d.h. einer Halbbrücke).

Unabhängig von der Verringerung der Verluste während der Diodenleitphase ist man beim Betrieb der MOSFETs in einer Phase bestrebt, die Zeitspanne zwischen dem Ausschalten des einen MOSFETs der Halbbrücke und dem Einschalten des anderen MOSFET der Halbbrücke auf ein Minimum zu begrenzen. Auch dies dient dazu, die in der Bodydiode auftretenden Verluste zu reduzieren. Allerdings darf keine Überschneidung zwischen dem Ausschalten des einen und dem Einschalten des anderen MOSFETs zwischen den Schaltvorgängen stattfinden, da ansonsten ein Brückenkurzschluss auftritt.

Um einen solchen Brückenkurzschluss zu vermeiden, weisen die MOSFETs jeweilige Spannungsdetektionsmittel auf, welche die über den jeweiligen Laststrecken abfallende Spannung (Drain-Source-Spannung) detektieren. Aus diesen Informationen kann ermittelt werden, dass z.B. der eine MOSFET ausgeschaltet ist, bevor der andere MOSFET eingeschaltet wird. Die Spannungserkennung über die Laststrecke ist jedoch aufwändig und erfordert viel Platz in einer Treiberschaltung, da die dazu notwendigen Bauelemente auf die über der Laststrecke abfallenden hohen Spannung ausgelegt sein müssen.

Es ist Aufgabe der Erfindung, eine Anordnung anzugeben, mit der eine Schaltzustandserkennung eines spannungsgesteuerten Halbleiterschaltelements auf einfachere und dennoch zuverlässige Weise erfolgen kann. Es ist weiterhin Aufgabe der Erfindung eine Brückenschaltung anzugeben, bei der auf einfache Weise ein Brückenkurzschluss vermieden werden kann.

Diese Aufgaben werden gelöst durch eine Anordnung gemäß den Merkmalen des Patentanspruchs 1 sowie eine Brückenschaltung gemäß den Merkmalen des Patentanspruchs 12. Vorteilhafte Ausgestaltungen ergeben sich aus den abhängigen Patentansprüchen.

Gemäß einem ersten Aspekt wird eine Anordnung zur Schaltzustandserkennung eines spannungsgesteuerten Halbleiterschaltelements, insbesondere eines Leistungs-Halbleiterschaltelements, das einen Steueranschluss und einen Lastanschluss umfasst, vorgeschlagen. Mittels einer zwischen dem Steueranschluss und dem Lastanschluss anfallenden Spannung wird das Halbleiterschaltelement leitend oder sperrend geschaltet. Die Anordnung umfasst ein Zustandserkennungsmittel, das in Abhängigkeit der an dem Steueranschluss anliegenden Spannung ein Schaltzustandssignal ausgibt, das anzeigt, ob das Halbleiterschlatelement leitet oder sperrt.

Die Anordnung zu Schaltzustanderkennung besitzt somit nicht wie bisherige Schaltzustandserkennungen die über den Lastanschlüssen des Halbleiterschaltelements anfallende Spannung (d.h. die Drain-Source-Spannung) als Eingangsparameter. Stattdessen reagiert das Zustandserkennungsmittel auf die an dem Steueranschluss anliegende Spannung. Der Vorteil dieser Anordnung liegt in ihrer Einfachheit, verbunden mit der Möglichkeit, das Zustandserkennungsmittel kostengünstig zu realisieren, da nur begrenzt Kriech- und Luftstrecken aufgrund der wesentlich geringeren Spannungen beachtet werden müssen.

Das Halbleiterschaltelement ist insbesondere ein MOSFET. Besonders bevorzugt ist das Halbleiterschaltelement ein SiC-MOSFET, welcher gegenüber einem aus Silicium bestehenden MOSFET mit einer größeren Schaltfrequenz betrieben werden kann.

Das Zustandserkennungsmittel umfasst ein spannungsgesteuertes Detektions-Halbleiterschaltelement, das einen Steueranschluss, einen ersten Lastanschluss und einen zweiten Lastanschluss umfasst, wobei der Steueranschluss des Detektions-Halbleiterschaltelements und der Steueranschluss des (zu überwachenden) Halbleiterschaltelements an einen gemeinsamen Knotenpunkt angeschlossen sind, an dem die zu detektierende Spannung anliegt. Das Detektions-Halbleiterschaltelement ist zweckmäßigerweise ein MOSFET. Aufgrund der Arbeitsweise der Anordnung ist es zweckmäßig, wenn der Detektions-MOSFET in einem gleichen Frequenzbereich wie das zu überwachende (Leistungs-)Halbleiterschaltelement betrieben werden kann. Wahlweise kann als Detektions-Halbleiterschaltelement ein Silicium-MOSFET oder ein SiC-MOSFET zum Einsatz kommen. Der gemeinsame Knotenpunkt, an den die Steueranschlüsse des Halbleiterschaltelements und des Detektions-Halbleiterschaltelement angeschlossen sind, ist an eine Treiberschaltung angeschlossen, mit deren Hilfe die Spannungssteuerung des Halbleiterschaltelements und des Detektions-Halbleiterschaltelements vorgenommen wird.

Der Lastanschluss des Halbleiterschaltelements und der erste Lastanschluss des Detektions-Halbleiterschaltelements sind im Betrieb der Anordnung mit unterschiedlichen Bezugsspannungen beaufschlagt. Dadurch ergibt sich der Effekt, dass das Detektions-Halbleiterschaltelement und das Halbleiterschaltelement mit einer zeitlichen Verzögerung zueinander geschaltet werden können, da deren jeweilige Steuerspannungen (d.h. Gate-Source-Spannungen) zwischen dem Steueranschluss und dem Lastanschluss unterschiedlich groß sind.

Insbesondere ist der Lastanschluss des Halbleiterschaltelements in Betrieb der Anordnung mit einem höheren Potential beaufschlagt als der erste Lastanschluss des Detektions-Halbleiterschaltelements. Hieraus ergibt sich der Effekt, dass das Detektions-Halbleiterschaltelement nach dem (Leistungs-)Halbleiterschaltelement ausschaltet bzw. das Detektions-Halbleiterschaltelement nach dem (Leistungs-)Halbleiterschaltelement einschaltet.

Es kann weiterhin zweckmäßig sein, wenn zwischen dem Knotenpunkt und dem Steueranschluss des Detektions-Halbleiterschaltelements ein erster Widerstand verschaltet ist. Durch die Größe des Widerstands kann eingestellt werden, mit welcher zeitlichen Verzögerung das Detektions-Halbleiterschaltelement nach dem (Leistung-)Halbleiterschaltelement ausschaltet bzw. mit welcher zeitlichen Verzögerung das Detektions-Halbleiterschaltelement nach dem (Leistungs-)Halbleiterschaltelement einschaltet.

Es kann weiterhin vorgesehen sein, dass der zweite Lastanschluss über einen zweiten Widerstand mit einem Potential verbunden ist, das höher als die Spannung an dem ersten Lastanschluss des Detektions-Halbleiterschaltelements ist, wobei eine an dem Knotenpunkt zwischen dem zweiten Lastanschluss des Detektions-Halbleiterschaltelements und dem zweiten Widerstand anliegende Spannung als das Schaltzustandssignal einer Auswerteeinheit zuführbar ist. Das Schaltzustandssignal wird somit durch das Detektions-Halbleiterschaltelement und eine sich aus dem Schaltzustand ergebende Spannung an einem Knotenpunkt, der mit der Auswerteeinheit verbunden ist, realisiert.

Die Auswerteeinheit ist insbesondere ein Übertrager mit einer Potentialsperre für einen Signalaustausch mit einer weiteren Anordnung, die wie in der hier ausgeführten Beschreibung ausgestaltet ist.

Ein Ausgangsanschluss der Auswerteeinheit ist mit einem ersten Eingang eines UND-Gatters verbunden, wobei dem ersten Eingang des UND-Gatters das Schaltzustandssignal der weiteren Anordnung zugeführt wird. Ein zweiter Eingang des UND-Gatters ist mit einer Ansteuersignal-Erzeugungseinheit verbunden, die dazu ausgebildet ist, gemäß einer vorgegebenen Steuerung ein Einschalt- oder ein Ausschaltsignal (allgemein Schaltsignal) für das Halbleiterschaltelement auszugeben und dem UND-Gatter zuzuführen.

Eine weitere Ausgestaltung sieht vor, dass ein Ausgang des UND-Gatters mit einer Treiberschaltung zum Ansteuern des Halbleiterschaltelements verbunden ist, wobei die Treiberschaltung ein Ansteuersignal an den Knotenpunkt anlegt, durch das die zwischen dem Steueranschluss und dem Lastanschluss des Halbleiterschaltelements anfallende Spannung sowie die zwischen Steueranschluss und dem ersten Lastanschluss des Detektions-Halbleiterschaltelements anfallende Spannung veränderbar ist, wobei das Steuersignal nur dann seinen Wert ändert, wenn das Schaltsignal der Anordnung einen Ein-Zustand und das Schaltzustandssignal der weiteren Anordnung einen Aus-Zustand des Halbleiterschaltelements der weiteren Anordnung, und umgekehrt, repräsentieren. Beim Vorsehen der Anordnung und der weiteren Anordnung und der Kopplung der beiden Anordnungen über die Auswerteeinheit kann dadurch sichergestellt werden, dass beim Verschalten der jeweiligen Halbleiterschaltelemente der Anordnung und weiteren Anordnung zu einer Brückenschaltung kein Brückenkurzschluss auftritt. Durch die Verarbeitung des Schaltsignals der vorgegebenen Steuerung, z.B. einer Ansteuereinheit für eine Halbbrücke, und dem Schaltzustandssignal ist sichergestellt, dass ein Einschalten eines Halbleiterschaltelements einer der Anordnungen erst dann erfolgen kann, wenn das Halbleiterschaltelement der anderen Anordnung zuvor ausgeschaltet wurde, und umgekehrt.

Eine derartige Anordnung zur Erkennung des Schaltzustands des Halbleiterschaltelements kann einerseits den Schaltzustand sicher detektieren, wobei gleichzeitig eine einfache Realisierbarkeit gegeben ist. Da die Erkennung durch Detektion der an dem Steueranschluss des Halbleiterschaltelements anliegenden Spannung erfolgt, ist es ausreichend, lediglich das Detektions-Halbleiterschaltelement und den zweiten Widerstand vorzusehen. Der erste Widerstand ist zweckmäßig, wenn eine Anordnung vorgesehen ist, um eine gezielte Zeitverzögerung zwischen der Detektion des Schaltzustands und dem Ansteuern des anderen Halbleiterschaltelements zu ermöglichen. Insbesondere ermöglicht es die Anordnung, das Halbleiterschaltelement zur Reduktion von Verlusten während der eingangs beschriebenen Diodenleitdauer einzuschalten, wobei ein Brückenkurzschluss dennoch zuverlässig verhindert werden kann.

Gemäß einem zweiten Aspekt der Erfindung wird eine Brückenschaltung mit einer Anordnung und einer weiteren Anordnung gemäß einem der vorhergehenden Ansprüche geschaffen, wobei das Halbleiterschaltelement der Anordnung und das Halbleiterschaltelement der weiteren Anordnung seriell zwischen einem ersten und einem zweiten Versorgungspotential verschaltet sind und wobei die Anordnung und die weitere Anordnung über die Auswerteeinheit zum Übertragen des Schaltzustandssignals der Anordnung an die weitere Anordnung und zum Übertragen des Schaltzustandssignals der weiteren Anordnung an die Anordnung miteinander gekoppelt sind. Wie beschrieben, ist bei einer derartigen Brückenschaltung sichergestellt, das trotz der Möglichkeit diese mit geringen Verlusten zu betreiben, kein Brückenkurzschluss in Betrieb auftreten kann.

Die Erfindung wird nachfolgend näher anhand eines Ausführungsbeispiels in der Zeichnung erläutert. Es zeigen:
- Fig. 1: eine schematische Darstellung eines elektrischen Ersatzschaltbildes einer erfindungsgemäßen Anordnung zur Schaltzustandserkennung eines spannungsgesteuerten Halbleiterschaltelements;
- Fig. 2: den zeitlichen Verlauf verschiedener Spannungen und eines Stroms, welche die Funktionsweise der erfindungsgemäßen Anordnung verdeutlichen; und
- Fig. 3: den zeitlichen Verlauf der über den jeweiligen Laststrecken anfallenden Spannungen zweier seriell miteinander verschalteter Halbleiterschaltelemente in Abhängigkeit eines Ansteuersignals eines der beiden Halbleiterschaltelemente.

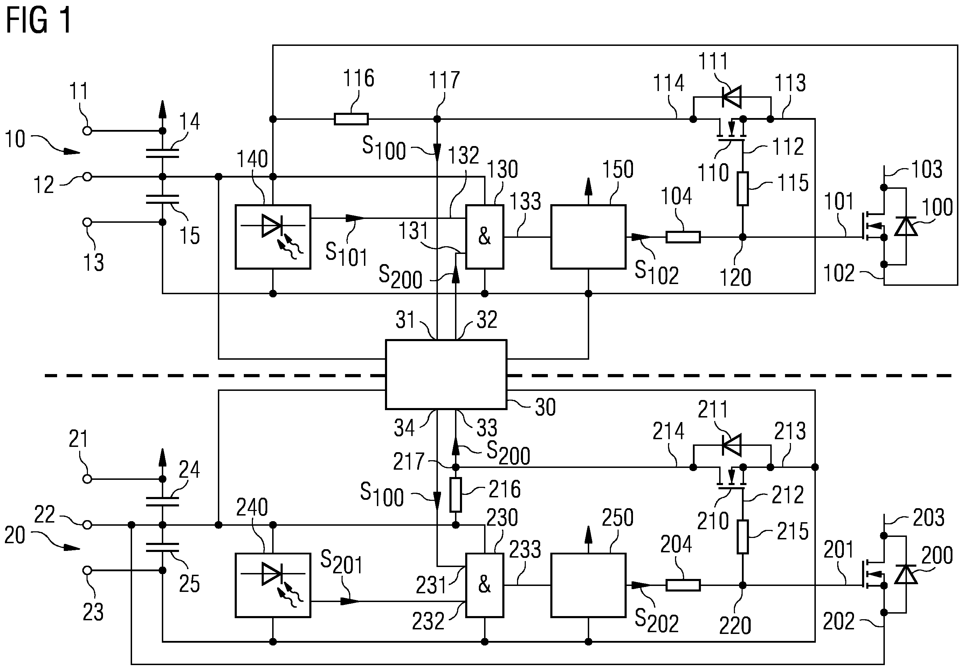

Fig. 1 zeigt eine schematische Darstellung einer erfindungsgemäß ausgebildeten, jedoch nur partiell dargestellten Halbbrückenschaltung. Bei dieser sind ein erstes Halbleiterschaltelement 100 (High-Side-Schaltelement) und ein zweites Halbleiterschaltelement 200 (Low-Side-Schaltelement) in einer dem Fachmann bekannten Weise seriell zwischen einem ersten und einem zweiten Versorgungspotentialanschluss verschaltet. Der Knotenpunkt zwischen dem ersten und dem zweiten Halbleiterschaltelement 100, 200 stellt einen Ausgang der Phase der Halbbrücke dar. Aus Gründen der Übersichtlichkeit ist diese dem Fachmann geläufige Verschaltung des ersten und des zweiten Halbleiterschaltelements 100, 200 in Fig. 1 nicht dargestellt.

Die Halbleiterschaltelemente 100, 200 sind insbesondere Leistungs-Halbleiterschaltelemente. Diese können in der Form von Si-MOSFETs oder als höherfreqent ansteuerbare SiC-MOSFETs bereitgestellt sein. Grundsätzlich eignet sich die nachfolgend beschriebene Anordnung zu Schaltzustandserkennung der Halbleiterschaltelemente 100, 200 für jedes spannungsgesteuerte Halbleiterschaltelement.

Jedem der Halbleiterschaltelemente 100, 200 ist eine Anordnung 10, 20 zur Schaltzustandserkennung des zugeordneten Halbleiterschaltelements zugeordnet. Die Schaltzustandserkennung für das erste Halbleiterschaltelement 100 erfolgt mittels der mit dem Bezugszeichen 10 gekennzeichneten Anordnung (nachfolgend erste Anordnung zur Schaltzustandserkennung). Die Schaltzustandserkennung des zweiten Halbleiterschaltelements 200 erfolgt mittels der mit dem Bezugszeichen 20 gekennzeichneten Anordnung (nachfolgend zweite Anordnung zur Schaltzustandserkennung). Die erste und die zweite Anordnung 10, 20 zur Schaltzustandserkennung sind jeweils identisch aufgebaut, so dass im Nachfolgenden im Wesentlichen lediglich eine Beschreibung der ersten Anordnung zur Schaltzustandserkennung erfolgen wird, wobei gleiche Elemente mit einem Bezugszeichen versehen sind, bei dem anstelle der ersten Ziffer "1" der Elemente der ersten Anordnung 10 bei Elementen der zweiten Anordnung 20 die Ziffer "2" gewählt ist.

Wie ohne weiteres aus dem Ersatzschaltbild der Fig. 1 ersichtlich ist, sind die erste Anordnung 10 und die zweite Anordnung 20 zur Schaltzustandserkennung des ersten bzw. zweiten Halbleiterschaltelements 100, 200 über eine Auswerteeinheit 30 miteinander gekoppelt. Die Auswerteeinheit 30 ist ein Übertrager mit einer Potentialsperre und einer Logik. Mit Hilfe des Übertragers 30 kann eine potentialfreie Übertragung von Logiksignalen zwischen der ersten und der zweiten Anordnung 10, 20 erfolgen, wie dies nachfolgend näher beschrieben wird.

Das erste Halbleiterschaltelement 100 umfasst in einer dem Fachmann bekannten Weise einen Steueranschluss 101 (Gate), einen ersten Lastanschluss 102 (Source) sowie einen zweiten Lastanschluss 103 (Drain). Der Steueranschluss 101 ist über einen Widerstand 104 mit einem Ausgang einer Treiberschaltung 150 verbunden. Am Ausgang der Treiberschaltung 150 wird durch diese ein Ansteuersignal s₁₀₂ abgegeben, durch welches die zwischen dem Steueranschluss 101 und dem ersten Lastanschluss 102 anliegende Spannung gesteuert wird. In Abhängigkeit der zwischen dem Steueranschluss 101 und dem ersten Lastanschluss 102 anliegenden Spannung ist das erste Halbleiterschaltelement entweder sperrend oder leitend geschaltet. Die zwischen dem Steueranschluss und dem ersten Lastanschluss 102 anliegende Spannung wird als Gate-Source-Spannung U_{GS} bezeichnet.

Die zur Erzeugung des Steuersignals s₁₀₂ notwendigen Spannungen sowie die Spannungen zur Versorgung der in der ersten Anordnung zur Schaltzustandserkennung vorgesehenen Komponenten werden durch in Fig. 1 nicht näher dargestellte Spannungsquellen erzeugt. Die Anordnung 10 umfasst hierzu einen ersten Versorgungspotentialanschluss 11 (bzw. 21 bei der zweiten Anordnung 20), an den eine erste, hohe Versorgungsspannung angelegt ist, einen zweiten Versorgungspotentialanschluss 12 (bzw. 22), an den eine zweite Versorgungsspannung, die kleiner als die erste Versorgungsspannung ist, angelegt ist, so wie einen Bezugspotentialanschluss 13 (bzw. 23), der mit einem Bezugspotential, z.B. Masse, verbunden ist. In einer dem Fachmann ebenfalls bekannten Weise ist zwischen dem ersten Versorgungspotentialanschluss 11 (21) und dem zweiten Versorgungspotentialanschluss 12 (22) ein Kondensator 14 (24) vorgesehen. Analog hierzu ist zwischen dem zweiten Versorgungspotentialanschluss 12 (22) und dem Bezugspotentialanschluss 13 (23) ein Kondensator 15 (25) verschaltet. Die an dem ersten Versorgungspotentialanschluss 11 (21) anliegende erste Versorgungsspannung beträgt z.B. 23V. Die an dem zweiten Versorgungspotentialanschluss 12 (22) anliegende zweite Versorgungsspannung beträgt beispielsweise 5V. An dem Bezugspotentialanschluss 13 (23) liegt ein Bezugspotential von z.B. 0V an.

Zur Ansteuerung des ersten Halbleiterschaltelements 100 ist dessen erster Lastanschluss 102 mit dem zweiten Versorgungspotentialanschluss 12 verbunden.

Die bereits beschriebene Treiberschaltung 150 ist zu ihrer Versorgung mit dem ersten Versorgungspotentialanschluss 11 und dem Bezugspotentialanschluss 13 verbunden. Ein Eingang der Treiberschaltung 150 ist mit einem Ausgang 133 eines UND-Gatters 130 verbunden. Ein erster Eingang 131 des UND-Gatters 130 ist mit einem Ausgang 32 für ein von der zweiten Anordnung 20 erzeugtes Schaltzustandssignal s₂₀₀ verbunden. Ein zweiter Eingang 132 des UND-Gatters 130 ist mit einem Ausgang einer Ansteuersignal-Erzeugungseinheit 140 verbunden. Die Ansteuersignal-Erzeugungseinheit 140 ist dazu ausgebildet, gemäß einer vorgegebenen Steuerung (z.B. einer Ansteuereinheit für die Halbbrückenschaltung) ein Schaltsignal s₁₀₁ für das erste Halbleiterschaltelement 100 auszugeben und dem UND-Gatter 130 an seinem zweiten Eingang 132 zuzuführen. Die Ansteuersignal-Erzeugungseinheit 140 umfasst zweckmäßigerweise einen Lichtwellenleiter-Empfänger, der, galvanisch getrennt, das beschriebene Ansteuersignal der Ansteuereinheit empfängt und als Schaltsignal s₁₀₀ an seinem Ausgang ausgibt.

Das UND-Gatter 130 und die Ansteuersignal-Erzeugungseinheit 140 sind zu deren Versorgung jeweils mit dem zweiten Versorgungspotentialanschluss 12 und dem Bezugspotentialanschluss 13 verbunden.

Die eigentliche Schaltzustandserkennung des ersten Halbleiterschaltelements 100 erfolgt mit Hilfe eines Zustandserkennungsmittels 110. Das Zustandserkennungsmittel 110 umfasst ein Detektions-Halbleiterschaltelement 111, einen ersten Widerstand 115 sowie einen zweiten Widerstand 116.

Das Detektions-Halbleiterschaltelement 111 ist ein spannungsgesteuertes Halbleiterschaltelement, z.B. ein Si-MOSFET oder ein SiC-MOSFET. Prinzip bedingt weisen sowohl das Detektions-Halbleiterschaltelement 111 als auch das erste Halbleiterschaltelement 100 eine figürlich dargestellte Bodydiode auf, über welche ein Rückwärtsstrom fließen kann. Das Detektions-Halbleiterschaltelement 111 umfasst einen Steueranschluss 112 (Gate), einen ersten Lastanschluss 113 (Source) sowie einen zweiten Lastanschluss 114 (Drain). Der Steueranschluss 112 ist über den ersten Widerstand 115 mit einem Knotenpunkt 120 gekoppelt, an den der Steueranschluss 101 (Gate) des Halbleiterschaltelements 100 sowie der Widerstand 104 angeschlossen sind. Der erste Lastanschluss 113 ist mit dem Bezugspotentialanschluss 13 gekoppelt. Der zweite Lastanschluss 114 des Detektions-Halbleiterschaltelements 111 ist über den zweiten Widerstand 116 mit dem zweiten Versorgungspotentialanschluss 12 gekoppelt. Ein zwischen dem zweiten Widerstand 116 und dem zweiten Lastanschluss 114 des Detektions-Halbleiterschaltelements 111 gebildeter Knotenpunkt 117, an dem ein den Schaltzustand repräsentierendes Schaltzustandssignal anliegt, ist mit einem Eingang 31 für das Schaltzustandssignal s₁₀₀ der Auswerteeinheit 30 verbunden.

Das Schaltzustandssignal s₁₀₀, das den Schaltzustand des ersten Halbleiterschaltelements 100 repräsentiert, wird der zweiten Anordnung 20 zur Schaltzustandserkennung an einem Ausgang 34 der Auswerteeinheit 30 zur Verfügung gestellt. Dabei wird das Schaltzustandssignal s₁₀₀ an einem ersten Eingang 231 dem UND-Gatter 230 der zweiten Anordnung der Schaltzustandserkennung zugeführt.

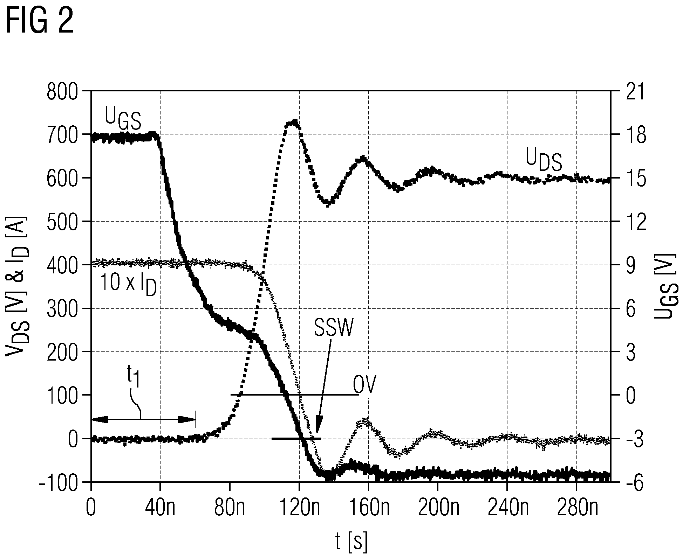

Die Funktionsweise der Anordnung beruht auf schaltspezifischen Eigenarten von MOSFETs. In Fig. 2 ist zur näheren Erläuterung das Ausschalten, z.B. des ersten Halbleiterschaltelements 100, dargestellt. Dabei sind jeweils der zeitliche Verlauf der Gate-Source-Spannung U_{GS}, der zeitliche Verlauf der Drain-Source-Spannung U_{DS} (d.h. der über der Laststrecke des ersten Halbleiterschaltelements 100 abfallenden Spannung) sowie der über die Laststrecke fließende Drain-Strom I_{D} dargestellt.

Nach Ausgabe eines Ausschaltbefehls durch eine in Fig. 1 nicht dargestellte Steuereinheit, welches der Ansteuersignal-Erzeugungseinheit zugeführt wird, benötigt die Treiberschaltung 150 in diesem Ausführungsbeispiel beispielhaft 40 ns bis die Gate-Spannung (d.h. die Spannung am Steueranschluss 101) anfängt zu fallen. Diese Verzögerung setzt sich aus den Totzeiten der Komponenten zur Erzeugung des Ansteuersignals s₁₀₂, d.h. der Ansteuersignal-Erzeugungseinheit und der Treiberschaltung 150 zusammen. Es ist anzumerken, dass bei dieser Betrachtung davon ausgegangen wird, dass das Schaltzustandssignal s₂₀₀ derart ist, dass das UND-Gatter 130 verzögerungsfrei den Ausschaltbefehl von der Ansteuersignal-Erzeugungseinheit 140 sofort an die Treiberschaltung 150 weiterleiten kann. Der Abfall der Gate-Spannung U_{GS} ist dabei nicht gleichmäßig, sondern wird durch eine Plateauphase (in etwa zwischen t = 60 ns und 100 ns) unterbrochen. In dieser Phase wird die Millerkapazität des ersten Halbleiterschaltelements 100 umgeladen und die Drain-Source-Spannung U_{DS} beginnt zu steigen. Nach Erreichen der Zwischenkreisspannung, die bei ca. 600V liegt, wird der Spannungsabfall am Steueranschluss 101 (Gate) wieder größer und erreicht den negativen Gate-Spannungsbereich, d.h. U_{GS} < 0. Zu diesem Zeitpunkt ist das erste Halbleiterschaltelement 100 ausgeschaltet. Dies ist in Fig. 2 durch den bei U_{GS} = 0V eingezeichneten waagerechten Strich gekennzeichnet. Bei einer Spannung von U_{GS} = -3V wird die Ausschaltschwelle des Detektions-Halbleiterschaltelements 103 durchschritten. Dies ist in Fig. 2 mit SSW gekennzeichnet.

Das Detektions-Halbleiterschaltelement 111 schaltet somit ebenfalls aus (d.h. ist sperrend geschaltet), wodurch die Spannung an dem Knotenpunkt 117 von der Spannung des Bezugspotentials 13 auf die Spannung des zweiten Versorgungspotentialanschlusses 12 ansteigt. Das an dem zweiten Versorgungspotentialanschluss 12 anliegende Versorgungspotential wird der Auswerteeinheit 30 als Schaltzustandssignal s₁₀₀ übertragen, und über den Ausgang 34 am ersten Eingang 231 des UND-Gatters 230 zur Verfügung gestellt. Erst wenn das Schaltzustandssignal s₁₀₀ ein Aus-Signal und gleichzeitig das Schaltsignal s₂₀₁ ein Ein-Signal sind, wird am Ausgang 233 des UND-Gatters ein entsprechendes Signal für die Treiberschaltung 250 erzeugt, so dass das Ansteuersignal s₂₀₂ für das zweite Halbleiterschaltelement 200 ein Einschalten ermöglicht.

Das verzögerte Ausschalten des Detektions-Halbleiterschaltelements 111 gegenüber dem "zu überwachenden" ersten Halbleiterschaltelement 100 ergibt sich daraus, dass der erste Lastanschluss 113 des Detektions-Halbleiterschaltelements 111 gegenüber dem ersten Lastanschluss 102 des ersten Halbleiterschaltelements 100 auf einem niedrigeren Potential liegt (Bezugspotential gegenüber dem höheren zweiten Versorgungspotential des zweiten Versorgungspotentialanschlusses 12). Der Lastanschluss des Detektions-Halbleiterschaltelements 111 liegt somit auf Null-Potential der Ansteuerung bzw. z.B. -5V aus Sicht des ersten Halbleiterschaltelements 100, so dass die anliegende Gate-Spannung aus Sicht des Detektions-Halbleiterschaltelements zwischen 0V (Bezugspotential) und 23V (erstes Versorgungspotential am ersten Versorgungspotentialanschluss) schwankt.

Das Maß der Verzögerung des Signals des Detektions-Halbleiterschaltelements 101 kann durch die Wahl der Größe des ersten Widerstands 115 verändert bzw. eingestellt werden.

In analoger Weise schaltet das Detektions-Halbleiterschaltelement 111 nach dem Einschalten des ersten Halbleiterschaltelements 100 zeitverzögert ein.

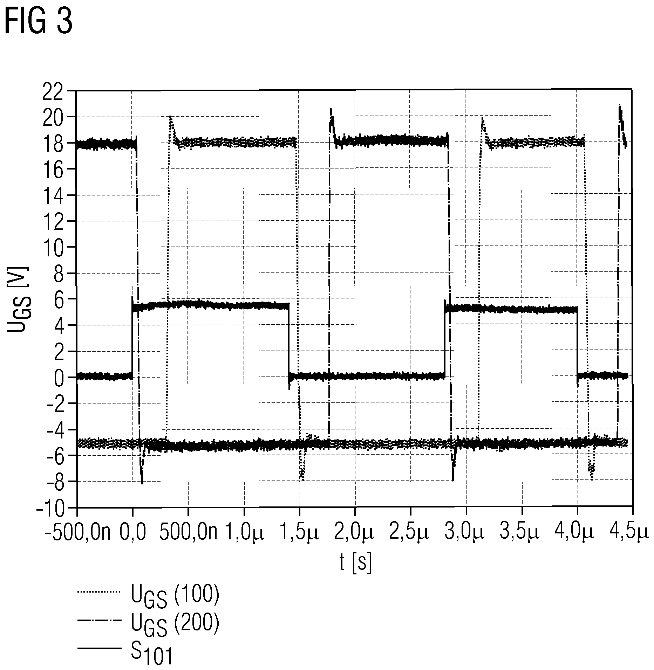

Die Funktionsweise der Schaltzustandserkennung des ersten Halbleiterschaltelements 100 kann anhand des Verlaufs der Gate-Source-Spannungen U_{GS} (100) des ersten Halbleiterschaltelements und der Gate-Source-Spannung U_{GS} (200) des zweiten Halbleiterschaltelements in Verbindung mit dem Schaltsignal s₁₀₁ für das erste Halbleiterschaltelement aus Fig. 3 ersehen werden. So erfolgt beispielsweise bei t = 0 s ein Anstieg des Schaltsignals s₁₀₁ von 0V auf knapp 6V, was einen Einschaltbefehl für das erste Halbleiterschaltelement 100 darstellt. Zeitverzögert sinkt die Gate-Source-Spannung U_{GS}(200) des ersten Halbleiterschaltelements von 18V auf etwa -5V ab. Bei t = 250 ns, d.h. mit ausreichendem zeitlichen Abstand nach dem Ausschalten des ersten Halbleiterschaltelements 100 steigt die Gate-Source-Spannung U_{GS}(100) des ersten Halbleiterschaltelements 100 an, wodurch dieses leitend geschaltet ist. Zum Zeitpunkt t = 1,3 µs sinkt das Schaltsignal s₁₀₁ wiederum auf Null ab, so dass das erste Halbleiterschaltelement 100 mit kurzer Zeitverzögerung sperrend geschaltet wird, was sich in einem Abfall der Gate-Source-Spannung von U_{GS}(100) auf -5V bemerkbar macht. Das Sperrendschalten des ersten Halbleiterschaltelements wird durch die erste Anordnung 10 detektiert und an das UND-Gatter 230 der zweiten Anordnung 20 übertragen. Infolgedessen kann nun der Einschaltbefehl für das zweite Halbleiterschaltelement 200 gegeben werden, so dass dieses zum Zeitpunkt t = 1,75 µs einschaltet, und so weiter.

## Patentansprüche

1. Anordnung (10) zur Schaltzustandserkennung eines spannungsgesteuerten Halbleiterschaltelements (100, 200), insbesondere eines Leistungs-Halbleiterschaltelements, das einen Steueranschluss (101, 201) und einen Lastanschluss (102, 202) umfasst, wobei mittels einer zwischen dem Steueranschluss (101, 201) und dem Lastanschluss (102, 202) anfallenden Spannung (U_{GS}) das Halbleiterschaltelement (100, 200) leitend oder sperrend geschaltet wird, wobei die Anordnung ein Zustandserkennungsmittel (110, 210) umfasst, das in Abhängigkeit der an dem Steueranschluss (101, 201) anliegenden Spannung ein Schaltzustandssignal (s100, s200) ausgibt.

2. Anordnung nach Anspruch 1, bei der das Zustandserkennungsmittel (110, 210) ein spannungsgesteuertes Detektions-Halbleiterschaltelement (111, 211) umfasst, das einen Steueranschluss (112, 212), einen ersten Lastanschluss (113, 213) und einen zweiten Lastanschluss (114, 214) umfasst, wobei der Steueranschluss (112, 212) des Detektions-Halbleiterschaltelements (111, 211) und der Steueranschluss (101, 201) des Halbleiterschaltelements (100, 200) an einen gemeinsamen Knotenpunkt (120) angeschlossen sind, an dem die zu detektierende Spannung anliegt.

3. Anordnung nach Anspruch 2, bei der der Lastanschluss (102, 202) des Halbleiterschaltelements (100, 200) und der erste Lastanschluss (113, 213) des Detektions-Halbleiterschaltelements (111, 211) im Betrieb der Anordnung mit unterschiedlichen Bezugsspannugen beaufschlagt sind.

4. Anordnung nach Anspruch 3, bei der der Lastanschluss (102, 202) des Halbleiterschaltelements (100, 200) im Betrieb der Anordnung mit einem höheren Potential beaufschlagt ist als der erste Lastanschluss (113, 213) des Detektions-Halbleiterschaltelements (111, 211).

5. Anordnung nach einem der Ansprüche 2 bis 4, bei der zwischen dem Knotenpunkt (120) und dem Steueranschluss (112, 212) des Detektions-Halbleiterschaltelements (111, 211) ein erster Widerstand (115, 215) verschaltet ist.

6. Anordnung nach einem der Ansprüche 2 bis 5, bei der der zweite Lastanschluss (114, 214) über einen zweiten Widerstand (116, 216) mit einem Potential verbunden ist, das höher als die Spannung an dem ersten Lastanschluss (113, 213) des Detektions-Halbleiterschaltelements (111, 211) ist, wobei eine an einem Knotenpunkt (117, 217) zwischen dem zweiten Lastanschluss (114, 214) des Detektions-Halbleiterschaltelements (111, 211) und dem zweiten Widerstand (116, 216) anliegende Spannung als das Schaltzustandssignal (s100, s200) einer Auswerteeinheit (30) zuführbar ist.

7. Anordnung nach Anspruch 6, bei der die Auswerteeinheit (30) ein Übertrager mit einer Potentialsperre ist für einen Signalaustausch mit einer weiteren Anordnung (20), die gemäß einem der vorhergehenden Ansprüche ausgestaltet ist.

8. Anordnung nach Anspruch 6 oder 7, bei der ein Ausgangsanschluss der Auswerteeinheit (30) mit einem ersten Eingang (131, 231) eines UND-Gatters (130, 230) verbunden ist, wobei dem ersten Eingang (131, 231) des UND-Gatters (130, 230) das Schaltzustandssignal (s200, s100) der weiteren Anordnung (20) zugeführt wird.

9. Anordnung nach Anspruch 8, bei der ein zweiter Eingang (132, 232) des UND-Gatters (130, 230) mit einer Ansteuersignal-Erzeugungseinheit (140, 240) verbunden ist, die dazu ausgebildet ist, gemäß einer vorgegebenen Steuerung ein Einschalt- oder ein Ausschaltsignal (s101) für das Halbleiterschaltelement (100, 200) auszugeben und dem UND-Gatter (130, 240) zuzuführen.

10. Anordnung nach Anspruch 8 oder 9, bei der ein Ausgang (133) des UND-Gatters (130) mit einer Treiberschaltung (150) zum Ansteuern des Halbleiterschaltelements (100, 200) verbunden ist, wobei die Treiberschaltung (140) ein Ansteuersignal (s102) an den Knotenpunkt (120) anlegt, durch das die zwischen dem Steueranschluss (101, 201) und dem Lastanschluss (102, 202) des Halbleiterschaltelements (100, 200) anfallende Spannung (UGS) sowie die zwischen dem Steueranschluss (112, 212) und dem ersten Lastanschluss (113, 213) des Detektions-Halbleiterschaltelements (110, 210) anfallende Spannung (U_{GS}) veränderbar ist, wobei das Ansteuersignal (s102) nur dann seinen Wert ändert, wenn das Schaltsignal (s101) der Anordnung (10) einen Ein-Zustand und das Schaltzustandssignal (s200) der weiteren Anordnung (20) einen Aus-Zustand des Halbleiterschaltelements (200, 100) der weiteren Anordnung (20), und umgekehrt, repräsentieren.

11. Anordnung nach einem der vorhergehenden Ansprüche, bei der das Halbleiterschaltelement (100, 200) ein SiC-MOSFET ist.

12. Halbbrückenschaltung mit einer Anordnung (10) und einer weiteren Anordnung (20) gemäß einem der vorhergehenden Ansprüche, wobei das Halbleiterschaltelement (100) der Anordnung (10) und das Halbleiterschaltelement (200) der weiteren Anordnung (20) seriell zwischen einem ersten und einem zweiten Versorgungspotentialanschluss verschaltet sind und wobei die Anordnung (10) und die weitere Anordnung (20) über die Auswerteeinheit (30) zum Übertragen des Schaltzustandssignals (s100) der Anordnung (10) an die weitere Anordnung (20) und zum Übertragen des Schaltzustandssignals (s200) der weiteren Anordnung (20) an die Anordnung (10) miteinander gekoppelt sind.
